# EUROPEAN PATENT APPLICATION

(11) **EP 3 334 021 A1**
(43) Date of publication of application: **13.06.2018**
(21) Application number: 17184982.1
(22) Date of filing: 04.08.2017
(51) Int. Cl.: H02M 1/08, H03K 17/06, H01L 29/16, H03K 17/042, H03K 17/10

(54) **GATE DRIVER CIRCUIT FOR POWER CONVERTERS INCORPORATING NORMALLY ON TRANSISTORS AND METHOD**

(30) Priority: 06.12.2016 IN 201641041580
(71) Applicant: Indian Institute of Science, Bangalore, Karnataka 560012 (IN)
(72) Inventor: Basu, Kaushik, Karnataka (IN); Parashar, Sanket, Karnataka (IN)
(74) Representative: Potter Clarkson LLP

(57) **Abstract**

The present invention is in relation to a synchronous buck converter comprising gate driver circuit, incorporated with passive elements for conversion of unipolar voltage produced by a standard gate driver to a bipolar voltage along with bootstrap technique to drive the normally on metal oxide semiconductor field effect transistor.

## Description

### Field of invention

The present invention is related to the field of electronics. In particular, the invention is in relation to a gate driving system that can generate programmable bipolar voltage, in order to drive normally on metal oxide based semiconductor field effect transistors. The present invention is capable of driving both the top and the bottom switches of a synchronous buck converter by using bootstrap technique. The proposed system uses available positive power supply and employs standard off the shelf drivers that produce unipolar positive voltage.

### Background of invention

Point of Load converter is a DC/DC switched mode power supply that supplies special integrated circuits (IC) such as micro-controllers, field-programmable gate arrays (FPGA) and the like, meeting high peak current demands with low noise margins. Synchronous buck converters are widely used as point of load converters for conversion of high DC voltage to low DC voltage with a function rating ranging from about 15V to about 3.3V, at around 6W. A conventional buck converter utilizes enhancement mode transistors for example Silicon based power metal oxide semiconductor field effect transistor (MOSFET) for point of load converters. Similarly, wide band gap devices such as Silicon Carbide based Junction field effect transistors (JFET) and Gallium Nitride(GaN) based high electron mobility transistors (HEMT) have been identified as promising power semiconductor devices due to their excellent switching characteristic along with very low on state voltage drop.

In comparison with Silicon based MOSFET's which are normally off devices, the normally on devices need a negative voltage to turn the switches off. If the control circuit has only positive power supply, a switched mode power supply (SMPS) is required to provide the negative voltage leading to reduction in efficiency of the system, with increase in size and cost.

In "Self powered gate driver for normally on silicon carbide junction field effect transistors without external power supply"; IEEE Transactions on Power Electronics, Volume: 28, Issue: 3, March 2013, a self-powered gate driver for normally ON silicon carbide JFETs is presented.

The details provided in the document describes a self-powered gate driver (SPGD)that derives power from the input dc voltage of the converter. As the available dc voltage is positive and unipolar, the SPGD employs a switched mode power supply (SMPS) to provide the negative voltage leading to reduction in efficiency and increase in size and cost.

Another disclosure titled "Experimental Validation of Normally-On GaN HEMT and Its Gate Drive Circuit in IEEE Transactions on Industry Applications, Volume: 51, Issue: 3, May-June 2015.

The details provided in the disclosure describes a circuit that translates a unipolar positive gate driver output to a unipolar negative voltage pulse to drive a normally on GaN transistor. The driver applies zero voltage when the switch is in on. A positive gate source voltage is necessary to ensure low drain source voltage drop across the transistor to minimize the on state conduction losses.

Thus, there is a need for gate driver circuits capable of providing bipolar voltage from a positive power supply without using SMPS; wherein existing gate drivers for normally off devices can be reused for normally on devices and also wherein the gate driver system that can utilize cost effective fabrications, for a synchronous buck converter with normally on semiconductor devices.

The present invention discloses a gate driver system for normally on semiconductor switches with standard gate drivers for normally off devices and passive elements capable of providing programmable bipolar gate driving signals from unipolar positive power supply, without making use of extra components such as switched mode power supply, thus offering a cost effective system with improved efficiency. The proposed system also employs a boot strapping technique obviating any need of an isolated SMPS to drive the top switch in a synchronous buck converter.

### Summary of invention:

Accordingly, the present invention is in relation to a synchronous buck converter comprising gate driver system with passive elements incorporated in the circuit to translate unipolar voltage produced by the standard gate driver to a programmable bipolar voltage along with bootstrap technique to drive the pair of, normally on MOSFETs in the synchronous buck converter.

### Brief description of drawings:

The features of the present invention can be understood in detail with the aid of appended figures. It is to be noted however, that the appended figures illustrate only typical embodiments of this invention and are therefore not to be considered limiting of its scope for the invention.
Figure 1 provides the schematic of the proposed gate driver system (GDS) incorporating a unipolar positive gate driver (GD), proposed voltage translator circuit along with boot strapping, supplied by a positive voltage. It also shows the target application of a PoL converter implemented with a synchronous buck converter which comprises of two normally on devices.
Figure 2 provides the schematic of the proposed voltage translator circuit.
Figure 3 provides the traditional gate driving circuit of a normally on device, driven by a bi-polar gate driver.
Figure 4 provides the photograph of the working example of the present invention.
Figure 5 and 6 provides oscilloscope captures of various different electrical signals described in details in the working example section confirming the operation of the proposed invention.

### Detailed description of invention:

The foregoing description of the embodiments of the invention has been presented for the purpose of illustration. It is not intended to be exhaustive or to limit the invention to the precise form disclosed as many modifications and variations are possible in light of this disclosure for a person skilled in the art in view of the Figures, description and claims. It may further be noted that as used herein and in the appended claims, the singular "a" "an" and "the" include plural reference unless the context clearly dictates otherwise. Unless defined otherwise, all technical and scientific terms used herein have the same meanings as commonly understood by person skilled in the art.

The present invention is in relation to a power converter comprising-
a) a gate driver system with passive elements in circuit; and
b) configured with a bootstrap device;
to generate programmable bipolar output voltage from unipolar input voltage.

In an embodiment of the present invention, the converter is a synchronous buck converter.

In another embodiment of the present invention, the converter drives a normally on metal oxide semiconductor switch.

In still another embodiment of the present invention, the gate driver of the system is a voltage level shifter and current booster circuit.

In yet another embodiment of the present invention, the passive elements comprises
a)Zener to control the voltage across the top driver (M1) and bottom driver (M2) of the gate driver system;
b) Resistor to limit the switching speed of the transistor; and
c) Capacitor to provide the negative voltage required to discharge the internal input capacitance of the transistors.

In yet another embodiment of the present invention, the bootstrap device is used to drive the top driver (M1).

In yet another embodiment of the present invention, the bootstrap device is a capacitor.

In yet another embodiment of the present invention, the capacitor is charged from the power source through a diode and resistor when the bottom driver (M2) is on.

The present invention is also in relation to a method for conversion of unipolar voltage to a bipolar voltage, said method comprising, conjugating power converter of present invention in voltage translator circuit.

The present invention discloses a synchronous buck converter comprising a gate driver system to control the switches of the power converter. The invention describes a circuit with passive elements for converting a unipolar voltage produced by the gate driver to a programmable bipolar voltage, necessary to drive the normally on switches. Also a bootstrap technique is used to drive the top MOSFET that does not require any additional isolated switched mode power supply. The present design of the invention bypasses the use of an additional switch mode power supply for obtaining bipolar voltage to drive normally on MOSFETs.

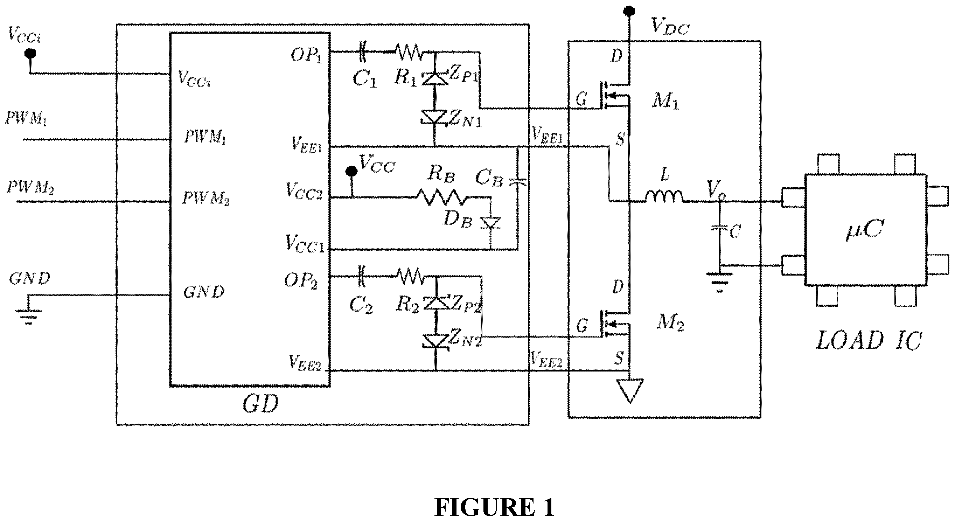

Figure 1 describes the proposed gate driver system (GDS) along with the power circuit of a synchronous buck converter (SB) supplying a microcontroller IC as a load. The entire system as shown in Figure 1 is called a point of load converter. In Figure 1, the first transistor (MOSFET (M₁)) and second transistor (MOSFET (M₂)) are normally on devices. V_{DC} is the input voltage and Vₒ is the regulated output voltage. GDS is the gate drive system of the synchronous buck converter (SB) which accepts the signal from PWM₁ and PWM₂ as digital signals and is powered by two positive voltage sources V_{CCi} and V_{CC}.

The GDS employs a standard gate driver (GD) as shown in the Figure 1. The gate driver (GD) is essentially a voltage level shifter and a current booster circuit. A pulse with an amplitude of V_{CCi} with respect to the ground (GND), applied at the input PWM₂ of GD, is translated to a pulse of an amplitude Vcc with respect to the same ground (V_{EE2} is connected to the ground) at the output pin OP₂ to drive the bottom device M₂. Similarly, for the said first transistor (M₁) a pulse at the input PWM₁ is translated to a pulse of an amplitude (V_{CC1} - V_{EE1}) with respect to the pin V_{EE1} at the output pin OP₁ of GD.

The bottom driver uses the positive power source Vcc connected at terminal V_{CC2}. This power supply is referenced to the system ground connected at terminal V_{EE2}. Similarly we need another power supply at V_{CC1} referenced at the terminal V_{EE1}, which is floating and cannot be connected to the system ground. So there is a need for an isolated power supply to drive the top MOSFET M₁. A bootstrap capacitor C_{B} is used to provide the supply for the top driver. This capacitor is charged through the diode D_{B} and resistance R_{B} from the source Vcc when the said second transistor (MOSFET M₂) is on. The charging path of the boot strap capacitor C_{B} shown as red in Figure 1. The resistance R_{B} is used to limit the charging current and the diode D_{B} ensures uni-directional charging. This explains boot strapping. This solution does not require an isolated power supply to drive the top switch.

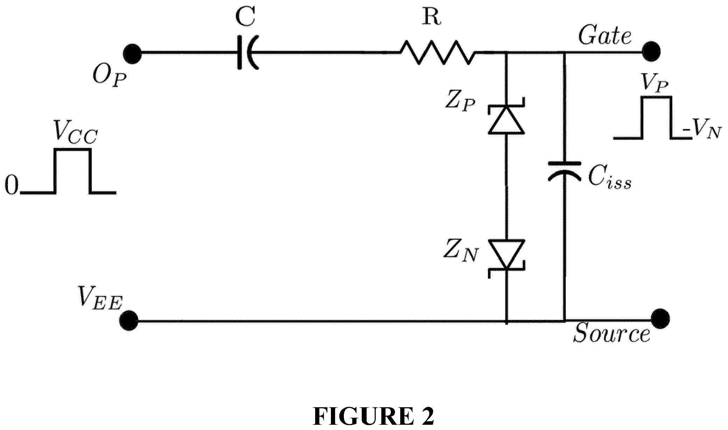

Output of GD, is unipolar. For example, at the output pin OP₂, the high level is V_{CC} and the low level is ground or zero. To drive a normally on MOSFET this signal needs to be translated to a bipolar signal, with levels V_{P} and -V_{N} respectively with respect to the ground or the V_{EE2}. This bi-polar voltage levels V_{P} and V_{N} can be designed based on the MOSFET characteristics. The positive voltage level V_{P} relates to the on state voltage drop of the device which results in conduction loss. The negative voltage level V_{N} must ensure proper turn off of the transistor. The circuit with resistance (R_{1,2}), capacitance (C_{1,2}) and Zener (Z_{P1,2} and Z_{N1,2}) is used to change the unipolar voltage to a bipolar voltage. This voltage translator circuit is identical for both the top and the bottom switches and shown in Figure 2.

Zeners Z_{P} and Z_{N} are used to control the positive (V_{P}) and the negative (-V_{N}) voltage across gate source terminals of the MOSFET. The Zener also protects the gate source terminal from transient over voltages. Capacitance C is used to provide the negative voltage required to discharge the internal input capacitance (Cᵢₛₛ) of the MOSFET. Resistance Ris used to limit the peak gate current and to control rise and fall time of the gate source voltage or in the other words the switching speed of the MOSFET. During the turn on and turn off transients, the power dissipation occurs in the proposed voltage translator circuit.

The operation of the voltage translator circuit for the MOSFET, consisting of the resistance (R), capacitance (C) and Zener (Z_{P} and Z_{N}) for converting unipolar voltage to bipolar voltage as shown in Figure 2, is explained below:

When the transistor is off, the Zener Z₁ is in the break down mode, applying a negative voltage of -V_{N} across the gate source terminals of the MOSFET. The gate driver output voltage is zero and the capacitor C is charged to V_{N}. To turn on the switch, a positive voltage of V_{CC} is applied across the gate driver output. This results in charging C and the voltage across the gate source terminal of the MOSFET also rises eventually. When this voltage reaches V_{P}, the Zener Z_{P} breaks down and clamps the gate source voltage at V_{P}. In order to ensure, the voltage actually reaches V_{P}, the capacitance of C must be greater than Cᵢₛₛ/(λ-1), where λ=V_{CC}/(V_{P}+V_{N}). To avoid any voltage overshoot across the gate source terminal, due to parasitic inductance, the capacitance of C must be close to Cᵢₛₛ/(λ-1). This also ensures minimum loss in the gate resistance R. Given the peak current capability of the driver, the gate resistance can be designed to minimize the switching time. After the gate voltage is clamped to V_{P}, the voltage across the capacitor asymptotically rises to (V_{CC}-V_{P}). To turn off the switch, a zero voltage is applied at the driver output causing the capacitor to discharge and the gate source voltage to fall. Once the gate source voltage falls below -V_{N}, the Zener Z_{N} breaks down and continues to clamp the gate source voltage to the same level. The capacitor C asymptotically discharges to a voltage of V_{N}.

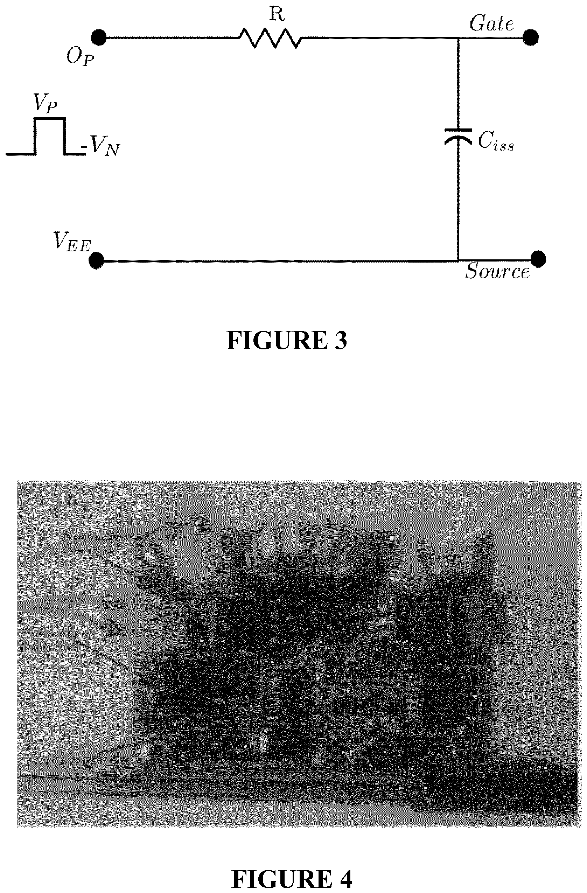

The efficiency and power density of the present gate driver circuit is compared with a standard gate driver circuit which uses a bipolar gate driver (Figure 3), capable of applying V_{P} and -V_{N} to charge and discharge the internal capacitance, Cᵢₛₛ, of the MOSFET. The bipolar gate driver needs to be supplied with an additional switched mode power supply (SMPS) to generate bipolar voltage from unipolar supply.

Power supplied by the driver in the present invention is
P = fKλ (V_{P} + V_{N}) ²Cᵢₛₛ, where f is the switching frequency, λ = Vcc/ (V_{P} + V_{N}) and K = C(λ - 1) /Cᵢₛₛ.

The power loss in the standard gate driver circuit is P = f(V_{P} + V_{N}) ²Cᵢₛₛ + P_{SMPS}. P_{SMPS} accounts for the additional loss in the SMPS. Both K and λ can be chosen close to unity. This shows that the present invention incurs similar loss when compared with a standard gate driver circuit involving additional SMPS and bipolar gate driver. In these circuits, the power loss is independent of the resistance R. If a bootstrap circuit is used in the standard gate driver circuit, it will incur similar loss when compared with the present invention. The standard gate driver circuit and present invention uses a resistance (R) to charge or discharge Cᵢₛₛ. The present invention has additional pair of Zeners (Z_{P,N}) and capacitor (C). But the standard gate driver circuit requires an additional SMPS and associated components. Additional bootstrapping may also will be required to provide bipolar voltage in the standard solution leading to lower power density. Hence, comparatively, the proposed solution will achieve better power density. The present invention is cost effective as it does not require an SMPS and bipolar gate driver. Off the shelf, unipolar gate driver, widely used for POLs with normally off MOSFETs can also be used in the present invention for generating unipolar voltage.

### Example:

Figure 4 shows a working example of the invention. The proposed gate driver system (GDS as in Figure 1) is implemented with a commercially available gate driver (GD as in Figure 1) ADµM7234, capable of driving normally off devices with unipolar positive voltage pulses. The GDS drives the two normally on transistors IXTA6N50D2 (M₁, M₂ as in Figure 1) of a Synchronous buck converter (SB as in Figure 1). The voltage translator circuit parameters are as follows: 1) Resistance (R as in Figure 2) =25.5Ω, 2) Capacitance (C as in Figure 2) =6.8 nF, 3) Positive Zener (Z_{P} as in Figure 2) with breakdown voltage V_{P}=2V and 4) Negative Zener (Z_{N} as in Figure 2) with breakdown voltage V_{N}=6V. The boot strap circuit parameters are as follows: 1) Boot strap capacitance (C_{B} as in Figure 1) 0.22 micro F 2) Boot strap Resistance (R_{B} as in Figure 1) 1.3 Ω3) Boot strap diode (D_{B} as in Figure 1).

The operating conditions are as follows: Input Voltage: 15V, Output voltage: 3V, Output power: 6W, Switching frequency, f: 250 kHz,

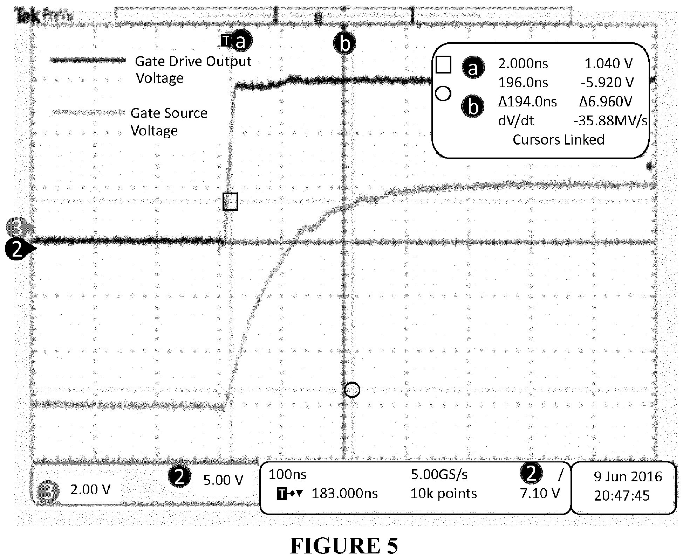

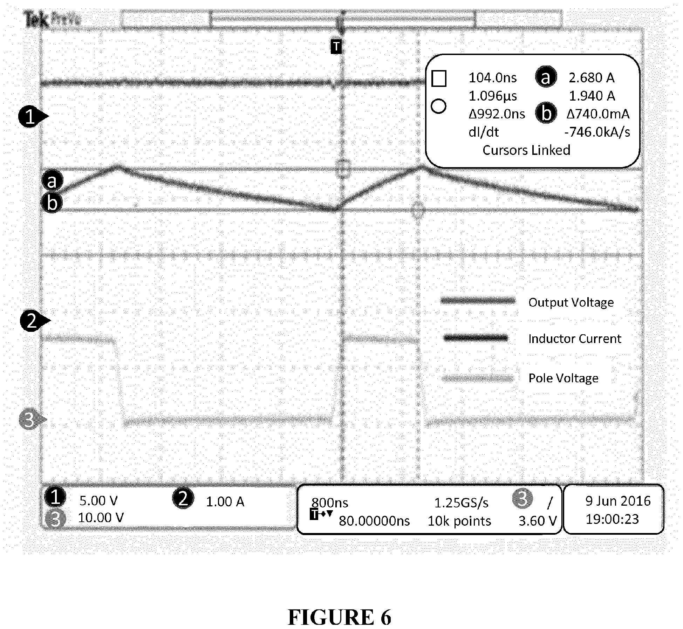

Figure 5 shows an oscilloscope capture of the output signal of the GD the voltage across the terminals OP₂ and V_{EE2} (as shown in Figure 1) the unipolar pulse in colour code red. This is a pulse of levels zero and 15 V. The positive input voltage 15V provides the supply to the GDS system and in particular to GD. The proposed voltage translator circuit converts this unipolar pulse to a bipolar one with levels -6V and 2V and applies it to the gate source terminals of normally on transistor M₂. This waveform is also shown in Figure 5, with colour code green. This confirms the operation of the voltage translator circuit. Figure 6 shows the typical voltage and current wave forms of a synchronous buck (SB) converter. The green is the pole voltage waveform (that is the voltage across the bottom transistor M₂) with levels 15V and zero. This confirms the proper switching of both the top and the bottom devices of the SB confirming boot strap operation. The red signal is the filter inductor current and finally blue is the desired output or load voltage of 3V.

Thus the present invention is in relation to a synchronous buck converter comprising gate driver system with passive elements for converting unipolar voltage to bipolar voltage along with bootstrap technique to drive pair of normally on MOSFETs in a synchronous buck converter.

The aforesaid description is enabled to capture the nature of the invention. It is to be noted however that the aforesaid description and the appended figures illustrate only a typical embodiment of the invention and therefore not to be considered limiting of its scope for the invention may admit other equally effective embodiments.

It is an object of the appended claims to cover all such variations and modifications as can come within the true spirit and scope of the invention.

## Claims

1. A power converter comprising-
a) a gate driver system with passive elements in circuit; and
b) configured with a bootstrap device;
to generate programmable bipolar output voltage from unipolar input voltage.

2. The power converter as claimed in claim 1, wherein converter is a synchronous buck converter.

3. The power converter as claimed in claim 1, wherein the converter drives a normally on metal oxide semiconductor switch.

4. The power converter as claimed in claim 1, wherein the gate driver of the system is a voltage level shifter and current booster circuit.

5. The power converter as claimed in claim 1, wherein the passive elements comprises
a)Zener to control the voltage across the top driver (M1) and bottom driver (M2) of the gate driver system;
b) Resistor to limit the switching speed of the transistor; and
c) Capacitor to provide the negative voltage required to discharge the internal input capacitance of the transistors.

6. The power converter as claimed in claim1, wherein the bootstrap device is used to drive the top driver (M1).

7. The power converter as claimed in claim 1, wherein the bootstrap device is a capacitor.

8. The power converter as claimed in claim 7, wherein the capacitor is charged from the power source through a diode and resistor when the bottom driver (M2) is on.

9. A method for conversion of unipolar voltage to a bipolar voltage, said method comprising, conjugating power converter of claim 1 in voltage translator circuit.
